# EUROPÄISCHE PATENTSCHRIFT

(11) **EP 4 214 522 B1**
(45) Veröffentlichungstag und Bekanntmachung des Hinweises auf die Patenterteilung: **10.04.2024**
(21) Anmeldenummer: 21806757.7
(22) Anmeldetag: 16.11.2021
(51) Int. Cl.: G01R 15/22, G01R 15/24, G01R 33/032

(54) **SENSOR MIT LICHTLEITERANSCHLUSS**
SENSOR WITH A LIGHT GUIDE CONNECTION
CAPTEUR POURVU D'UN CONNECTEUR OPTIQUE

(30) Priorität: 21.09.2020 DE 102020124516
(43) Veröffentlichungstag der Anmeldung: 26.07.2023
(73) Patentinhaber: duotec GmbH, 58553 Halver (DE)
(72) Erfinder: RÖNISCH, Arthur, 58566 Kierspe (DE); JOSLOWSKI, Lukas, 58644 Iserlohn (DE)
(74) Vertreter: Lippert Stachow Patentanwälte Rechtsanwälte
(86) Internationale Anmeldenummer: PCT/EP2021/081834
(87) Internationale Veröffentlichungsnummer: WO 2022/058625

(56) Entgegenhaltungen:
- WO-A1-2019/122693
- DE-A1-102015 208 151
- US-A1- 2011 051 145

## Beschreibung

Die Erfindung betrifft ein System und ein Verfahren zur Messung einer Stromstärke eines durch einen elektrischen Leiter fließenden elektrischen Stroms.

Die Messung elektrischer Stromstärken in elektrischen Leitern hat wegen der allgegenwärtigen Verwendung von elektronischen Bauteilen und dem damit einhergehenden Bedarf an einer Messung bzw. Überwachung von Stromflüssen erhebliche Bedeutung erlangt. Dabei ist es üblicherweise erforderlich, die Stromstärke in dem elektrischen Leiter zu ermitteln, während der elektrische Leiter in einem ersten Bauteil integriert ist, in dem er seine bestimmungsgemäße Funktion erfüllt. Die Messung zw. Ermittlung der Stromstärke erfolgt üblicherweise dadurch, dass ein Sensorelement vorgesehen wird, das über eine Anschlussleitung mit der Auswerteeinrichtung verbunden wird. Während der Messung muss sich das Sensorelement in einer definierten Position relativ zum Leiter befinden. Im Stand der Technik sind eine Vielzahl an Möglichkeiten zur Messung von Stromstärken in elektrischen Leitern bekannt. Beispielsweise ist bekannt, als Sensorelement einen Messwiderstand vorzusehen, wobei während einer Stromstärkenmessung über die Anschlussleitung von der Auswerteeinrichtung ein über dem Messwiderstand anliegender Spannungsabfall gemessen wird und der Messwiderstand so in den Stromkreis des elektrischen Leiters integriert wird, dass über den Spannungsabfall ein Wert für die durch den Leiter fließende Stromstärke ermittelt wird. Beispielsweise ist bekannt, als Sensorelement ein magnetfeldsensitives Sensorelement vorzusehen, beispielsweise ein Hall-Element oder ein spulenbasiertes Element, wobei dieses magnetfeldsensitives Sensorelement in einer räumlich festgelegten Position relativ zum Leiter angeordnet wird und die am Sensorelement anliegende Spannung gemessen wird. Wegen der Abhängigkeit der vom Sensorelement ausgegebenen Ausgangsspannung von der am Sensorelement anliegenden Magnetfeldstärke und der räumlich festgelegten Anordnung des Sensorelements relativ zum elektrischen Leiter kann durch die vom Sensorelement ausgegebene Ausgangsspannung ein Wert für die durch den Leiter fließende Stromstärke ermittelt werden.

Die im Stand der Technik bekannten Systeme und Verfahren eignen sich grundsätzlich bereits sehr gut für eine präzise Bestimmung einer durch den elektrischen Leiter fließenden Stromstärke. Doch bringen die im Stand der Technik bekannten Systeme und Verfahren verschiedene Nachteile mit sich. Die herkömmliche Verwendung von Messwiderständen als Sensorelement macht eine Integration des Sensorelements in den Stromkreis des elektrischen Leiters und eine galvanische Kontaktierung des Messwiderstands erforderlich, was zum einen die Gefahr von Messverfälschungen mit sich bringt, zum anderen die Herstellung des ersten Bauteils mit dem elektrischen Leiter verkompliziert und somit verteuert, wodurch darüber hinaus eine Skalierbarkeit, d. h. eine Verwendung einer einfachen Messvorrichtung für die Messung von Stromstärken in einer Vielzahl unterschiedlicher elektrischen Leiter unmöglich gemacht ist, und darüber hinaus ist hierdurch eine Stromstärkenmessung in schwierigen Umgebungen, beispielsweise in feuchter Atmosphäre oder sonstigen chemisch aggressiven Medien, wegen der zwingend erforderlichen elektrischen Kontaktierung des Messwiderstands äußerst erschwert. Auch die Nutzung von gattungsgemäßen Verfahren und Systemen, bei denen magnetfeldsensitive Sensorelemente zum Einsatz kommen, kann diese Nachteile nicht beheben. Zwar ist bei der Verwendung eines solchen magnetfeldsensitiven Sensorelements keine Integration des Sensorelements in den Stromkreis des elektrischen Leiters erforderlich. Doch muss ein solches magnetfeldsensitives Sensorelement ebenfalls durch galvanische Kontaktierung ausgelesen werden, was dieselben Nachteile mit sich bringt, die bei der Verwendung von Messwiderständen als Sensorelementen auftreten, und darüber hinaus muss dabei gewährleistet sein, dass das Sensorelement in einer festgelegten Position relativ zum Leiter angeordnet ist, wenn es zur Messung der in dem Leiter fließenden Stromstärke ausgelesen wird. Im Stand der Technik vorgesehene Lösungsansätze zum Beheben der genannten Nachteile beruhen zumeist darauf, dass in dem ersten Bauteil das Sensorelement gemeinsam mit einem Funkübertragungsmodul vorgesehen wird, über das ein Auslesen des Sensorelements durch einen entsprechenden Funkempfänger, der in einem zweiten Bauteil zusammen mit der Auswerteeinrichtung integriert ist, ermöglicht ist. Hierdurch wird zwar eine Skalierbarkeit, d. h. eine Verwendung desselben zweiten Bauteils zum Messen elektrischer Stromstärken bei unterschiedlichen Leitern, ebenso erreicht wie eine galvanische Trennung zwischen der Auswerteeinrichtung und dem elektrischen Leiter, doch führen diese Lösungsansätze zu erheblichen Herstellkosten sowohl auf Seiten des ersten Bauteils mit dem elektrischen Leiter als auch auf Seiten des zweiten Bauteils. Ein weiterer Lösungsansatz zum Messen eines elektrischen und/oder magnetischen Feldes, das von einem elektrischen Leiter erzeugt wird, ist in WO 2019/122693 A1 beschrieben. Gemäß diesem Lösungsansatz wird das elektrische oder magnetische Feld dadurch gemessen, dass Licht mit einer definierten Polarisation durch ein Gas hindurchgesendet wird, in dem der Zeeman- bzw. Stark-Effekt auftritt, wobei das Licht, nachdem es durch das Gas hindurchgetreten ist, in Anteile unterschiedlicher Polarisationen aufgeteilt wird, wobei durch Verhältnisbildung der Lichtintensität mit unterschiedlicher Polarisation auf die zu messende Stärke des Magnetfelds bzw. elektrischen Felds zurückgeschlossen wird, indem die Abhängigkeit des Einflusses, den das Gas auf die Rotation der Polarisation des durch ihn hindurchtretenden Lichts in Abhängigkeit von der Stärke des anliegenden Felds hat, berücksichtigt wird.

Der vorliegenden Erfindung liegt die Aufgabe zugrunde, ein System und ein Verfahren zur Messung einer Stromstärke eines durch einen elektrischen Leiter fließenden Stroms bereitzustellen, mit dem zumindest einige der Nachteile bekannter Systeme und Verfahren zumindest teilweise behoben werden.

Als eine Lösung der genannten der Erfindung zugrundeliegenden Aufgabe schlägt die Erfindung ein System mit den Merkmalen gemäß Anspruch 1 vor. Ein System umfasst ein erstes Bauteil, das den elektrischen Leiter umfasst, sowie ein zweites Bauteil, das ein von dem ersten Bauteil separates Bauteil ist. Erstes und zweites Bauteil sind somit voneinander lösbar und unabhängig voneinander bewegbar. Das zweite Bauteil umfasst eine Auswerteeinrichtung. Das System umfasst ferner ein magnetfeldsensitives Sensorelement und eine Anschlussleitung. Das magnetfeldsensitive Sensorelement ist ein Element, das eine messbare Eigenschaft aufweist, die sich in Abhängigkeit von dem an dem Sensorelement anliegenden Magnetfeld verändert, so dass über eine Veränderung der Eigenschaft des Sensorelements eine Messung der Stromstärke vorgenommen werden kann. Beispielsweise kann das Sensorelement als Hall-Element ausgebildet sein, das als seine von dem Magnetfeld abhängige Eigenschaft eine Ausgangsspannung ausgibt. Beispielsweise kann das Sensorelement ein Festkörperelement sein, in dem Energieniveaus der Elektronen eine Abhängigkeit von dem Magnetfeld aufweisen, so dass bei einer Anregung des Festkörperelements mit einer festgelegten, gleichbleibenden externen Energie das Festkörperelement in Abhängigkeit von dem anliegenden Magnetfeld Licht abstrahlt, dessen wellenlängenabhängiger Intensitätsverlauf von der Magnetfeldstärke des anliegenden Magnetfelds abhängt. Bei dem Magnetfeld ist selbstverständlich auf das Magnetfeld bzw. seine Magnetfeldstärke am Ort des Sensorelements abgestellt. In einem Betriebszustand des Systems, in dem die Komponenten des Systems in einer festgelegten Anordnung zueinander angeordnet sind, ist das Sensorelement in einer relativ zu dem elektrischen Leiter determinierten Betriebsposition positionsfest an dem ersten Bauteil fixiert. Hierdurch ist sichergestellt, dass eine Veränderung des von dem Sensorelement erfassten Magnetfelds durch eine Veränderung der Stromstärke des durch den Leiter fließenden Stroms bedingt ist und nicht beispielsweise etwa durch eine Veränderung der Position des Sensorelements relativ zum elektrischen Leiter.

In dem Betriebszustand ist das Sensorelement ferner durch die Anschlussleitung mit dem zweiten Bauteil verbunden, indem die Anschlussleitung mit einem ersten Ende an dem Sensorelement und mit einem zweiten Ende an dem zweiten Bauteil angeschlossen ist. Die Anschlussleitung ist somit dazu ausgebildet, in dem Betriebszustand eine Information betreffend die von dem anliegenden Magnetfeld abhängige Eigenschaft des Sensorelements von dem Sensorelement zu dem zweiten Bauteil und somit zu der in dem zweiten Bauteil integrierten Auswerteeinrichtung zu übertragen. Das zweite Bauteil weist dabei bevorzugt eine Schnittstelle auf, über die die Auswerteeinrichtung in dem Betriebszustand mit dem zweiten Ende der Anschlussleitung verbunden ist. Die zweite Anschlussleitung kann beispielsweise mit ihrem zweiten Ende unlösbar an der Schnittstelle des zweiten Bauteils fixiert sein, so dass die Anschlussleitung in dem zweiten Bauteil integriert ist. Alternativ kann die Anschlussleitung an ihrem zweiten Ende korrespondierend zu der Schnittstelle des zweiten Bauteils ausgebildet sein, wobei im Betriebszustand die Anschlussleitung und das zweite Bauteil mit ihren zueinander korrespondierenden Schnittstellen lösbar miteinander verbunden sind zum Sicherstellen einer Übertragung der Information betreffend die magnetfeldabhängige Eigenschaft des Sensorelements von dem Sensorelement zu der Auswerteeinrichtung. Entsprechend weist in einer Ausführungsform das Sensorelement eine Schnittstelle auf, die in dem Betriebszustand mit dem ersten Ende der Anschlussleitung verbunden ist zum Gewährleisten eines Auslesens der magnetfeldabhängigen Informationen von dem Sensorelement über die Anschlussleitung. Die Anschlussleitung kann beispielsweise unlösbar mit der Schnittstelle des Sensorelements verbunden sein, so dass Sensorelement und Anschlussleitung ein einstückiges Bauteil darstellen, oder die Anschlussleitung kann an ihrem ersten Ende eine Schnittstelle aufweisen, die mit der Schnittstelle des Sensorelements dergestalt korrespondiert, dass das Sensorelement und das erste Ende der Anschlussleitung in dem Betriebszustand miteinander lösbar verbunden sind unter Gewährleistung eines Auslesens des Sensorelements über die Anschlussleitung, wobei in einer Ausführungsform hierbei das erste Bauteil und das erste Ende der Anschlussleitung korrespondierende mechanische Schnittstellen aufweisen, durch die eine Relativposition des ersten Endes der Anschlussleitung relativ zum ersten Bauteil in dem Betriebszustand festgelegt ist und dabei die Schnittstellen von dem sich in der Betriebsposition befindlichen Sensorelement und dem ersten Ende der Anschlussleitung miteinander verbunden sind. Erfindungsgemäß ist die Anschlussleitung als ein Lichtleiter ausgebildet, beispielsweise umfassend zumindest eine Glasfaser. In jedem Fall ist die Anschlussleitung ein räumlich begrenzter Körper, in dem Licht determiniert geleitet werden kann. Die Anschlussleitung kann beispielsweise auch als transparenter Kunststofflichtleiter ausgebildet sein. In einer Ausführungsform ist das Sensorelement mit dem ersten Ende der Anschlussleitung unlösbar verbunden. In einer Ausführungsform ist das Sensorelement mit dem ersten Bauteil unlösbar verbunden. In einer Ausführungsform ist das Sensorelement mit dem ersten Ende der Anschlussleitung und mit dem ersten Bauteil unlösbar verbunden. In einer Ausführungsform ist die Anschlussleitung als eine von dem ersten Ende bis zum zweiten Ende ununterbrochen durchgehende Anschlussleitung ausgebildet. In einer Ausführungsform weist die Anschlussleitung einen ersten Anschlussleitungsabschnitt auf, der das erste Ende ausbildet, sowie einen zweiten Anschlussleitungsabschnitt, der das zweite Ende ausbildet, wobei die beiden Anschlussleitungsabschnitte in dem Betriebszustand lösbar miteinander verbunden sind.

In dem Betriebszustand sind die beiden Bauteile voneinander galvanisch getrennt und mittels der Anschlussleitung mit einer lichtleitenden Verbindung lösbar miteinander verbunden, wobei durch die lichtleitende Verbindung eine Energieversorgung des magnetfeldsensitiven Sensorelements durch das zweite Bauteil gewährleistet ist und/oder eine Übertragung von Sensordaten von dem magnetfeldsensitiven Sensorelement zu der Auswerteeinrichtung gewährleistet ist. Die Sensordaten umfassen dabei Informationen über die oben erläuterten magnetfeldabhängige Eigenschaft des Sensorelements. In einer Ausführungsform, in der die lichtleitende Verbindung eine Energieversorgung des magnetfeldsensitiven Sensorelements durch das zweite Bauteil gewährleistet, sind Sensorelement, zweites Bauteil und Anschlussleitung dergestalt zueinander korrespondierend ausgebildet, dass in dem Betriebszustand eine Energiezuführung von dem zweiten Bauteil zu dem Sensorelement zum Betreiben des Sensorelements und somit zum Gewinnen von Sensordaten von dem Sensorelement erfolgt. Beispielsweise kann die Energieversorgung darin bestehen, dass über die Anschlussleitung Lichtstrahlen, insbesondere Lichtpulse, von dem zweiten Bauteil an das Sensorelement übertragen werden, beispielsweise indem das zweite Bauteil eine Diode, insbesondere eine Laserdiode, aufweist, und indem die Anschlussleitung an eine als optischer Anschluss des Sensorelements ausgebildete Schnittstelle des Sensorelements angeschlossen ist. Hierdurch kann beispielsweise eine Anregung des Sensorelements erfolgen, die das Sensorelement dazu anregt, Licht mit von dem anliegenden Magnetfeld abhängigen wellenlängenabhängigen Intensitätsverlauf abzustrahlen. Allgemein bevorzugt weist das zweite Bauteil einen Versorgungsanschluss zum Anschließen des zweiten Bauteils an eine Energiequelle, beispielsweise einen Akku oder eine Versorgungsleitung, auf. In einer Ausführungsform ist in dem Betriebszustand über die lichtleitende Verbindung eine Übertragung von Sensordaten von dem magnetfeldsensitiven Sensorelement zu der Auswerteeinrichtung gewährleistet, beispielsweise indem das zweite Bauteil, die Anschlussleitung und das Sensorelement dergestalt zueinander korrespondierend ausgebildet sind, dass das Sensorelement Lichtstrahlen abgeben kann, in denen die Sensordaten als Information enthalten sind. Entsprechend kann die Anschlussleitung an als optische Anschlüsse ausgestaltete Schnittstellen von Sensorelement und zweitem Bauteil angeschlossen sein. Beispielsweise kann das Sensorelement eine Diode umfassen, wobei es die Sensordaten mittels der Diode in die Anschlussleitung einspeist, beispielsweise indem die Sensordaten über eine Frequenzmodulation auf den von der Diode ausgesandten Lichtstrahl aufmoduliert sind oder indem die Sensordaten als Lichtpulslänge kodiert sind. Beispielsweise kann das Sensorelement als Festkörperelement ausgebildet sein, das bei einer Anregung durch externe Energie, insbesondere auf eine Energieversorgung durch das zweite Bauteil hin, Licht abstrahlt, insbesondere indem in dem Festkörperelement Elektronen von einem angeregten Energieniveau auf ein stabiles Energieniveau fallen, wobei das Sensorelement als Sensordaten Licht mit einem von der anliegenden Magnetfeldstärke abhängigen wellenlängenabhängigen Intensitätsverlauf ausgibt.

Die Erfindung bringt im Vergleich zu herkömmlichen Systemen wesentliche Vorteile mit sich. Durch die positionsfeste Fixierung des Sensorelements relativ zu dem elektrischen Leiter in einer determinierten Betriebsposition in dem Betriebszustand ist sichergestellt, dass die von dem Sensorelement ausgelesenen Sensordaten eine eindeutige Abhängigkeit von dem Magnetfeld aufweisen, das der elektrische Leiter erzeugt, wenn Strom durch den elektrischen Leiter fließt. In einer Ausführungsform ist hierzu das Sensorelement in dem ersten Bauteil integriert, so dass das Sensorelement dauerhaft, insbesondere nicht ohne Zerstörung lösbar, die determinierte Betriebsposition relativ zu dem elektrischen Leiter innehat. In einer Ausführungsform ist an dem Sensorelement oder einer das Sensorelement umfassenden Komponente des Systems eine mechanische Schnittstelle vorgesehen, die korrespondierend zu einer an dem ersten Bauteil vorgesehenen mechanischen Schnittstelle ausgebildet ist, wobei zur Realisierung des Betriebszustands die beiden zueinander korrespondierenden mechanischen Schnittstellen von Sensorelement bzw. Sensorelement umfassender Komponente und erstem Bauteil miteinander in Eingriff gebracht werden, wodurch zwingend die determinierte Betriebsposition des Sensorelements in dem Betriebszustand festgelegt ist. Durch die Ausgestaltung der Anschlussleitung als Lichtleiter ist darüber hinaus die galvanische Entkopplung zwischen Sensorelement und Auswerteeinrichtung, insbesondere zwischen erstem und zweitem Bauteil, während der Durchführung einer Messung gewährleistet, d. h. während sich das System in seinem Betriebszustand befindet und durch die Auswerteeinrichtung Sensordaten aus dem Sensorelement auslesbar sind. Darüber hinaus ist, anders als bei elektrischen Leitern, die Ausgestaltung eines Lichtleiters unproblematisch chemisch inert möglich. Daher eignet sich das erfindungsgemäße System gerade auch zur Verwendung in chemisch anspruchsvoller Umgebung. Darüber hinaus ist das erfindungsgemäße System kostengünstig auf große Maßstäbe skalierbar. So können beispielsweise verschiedene erste Bauteile vorgesehen sein, die jeweils eine mechanische Schnittstelle aufweisen, insbesondere jeweils eine identische mechanische Schnittstelle aufweisen, die korrespondierend zu einer an dem Sensorelement oder einer Systemkomponente umfassend das Sensorelement ausgebildeten mechanischen Schnittstelle ausgebildet ist oder, bei Integration des Sensorelements in die ersten Bauteile, korrespondierend zu einer an der Anschlussleitung oder an dem zweiten Bauteil vorgesehenen mechanischen Schnittstelle ausgebildet ist. Hierdurch kann auf sehr einfache Weise durch stets dasselbe Messprinzip über die Anschlussleitung ein Auslesen von Sensordaten und/oder eine Energieversorgung des Sensorelements durch das zweite Bauteil gewährleistet sein, wobei insbesondere zur Realisierung des Betriebszustands ausschließlich eine mechanische Kopplung von erstem und zweitem Bauteil, die als separate Bauteile ausgebildet sind, erforderlich ist, wobei bevorzugt durch diese mechanische Kopplung eine, insbesondere ausschließlich, optische Kopplung zwischen dem Sensorelement und der Auswerteeinrichtung gewährleistet ist.

In einer Ausführungsform ist entweder die Anschlussleitung unlösbar an einer Anschlusseinrichtung des zweiten Bauteils angeschlossen und somit in dem zweiten Bauteil integriert, oder die Anschlussleitung ist durch zusammenwirkende, an ihrem zweiten Ende und an dem zweiten Bauteil vorgesehene mechanische Schnittstellen in dem Betriebszustand lösbar an der Anschlusseinrichtung des zweiten Bauteils angeschlossen. Bevorzugt legen die korrespondierenden mechanischen Schnittstellen von zweitem Bauteil und zweitem Ende der Anschlussleitung die Relativposition des zweiten Endes der Anschlussleitung zum zweiten Bauteil eindeutig fest. Durch die unlösbare Integration der Anschlussleitung in das zweite Bauteil oder das Vorsehen entsprechender mechanischer Schnittstellen ist eine fehlerarme Sensordatenübertragung und/oder eine fehlerarme Energieversorgung des Sensorelements durch das zweite Bauteil in dem Betriebszustand besonders zuverlässig gewährleistet. In einer Ausführungsform ist das Sensorelement in dem ersten Bauteil relativ zu dem elektrischen Leiter positionsfest integriert oder durch Zusammenwirken der mechanischen Schnittstellen von Sensorelement und erstem Bauteil in dem Betriebszustand lösbar in der determinierten Betriebsposition an dem ersten Bauteil fixiert. Durch die positionsfeste Integration des Sensorelements in dem ersten Bauteil oder das Vorsehen von entsprechenden mechanischen Schnittstellen ist besonders zuverlässig gewährleistet, dass die Sensordaten eine klar definierte Abhängigkeit von der durch den Leiter fließenden Stromstärke aufweisen. In einer Ausführungsform ist die Anschlussleitung in dem Betriebszustand in einer determinierten Anschlussposition an dem Sensorelement angeschlossen, wobei die Anschlussleitung in dem Betriebszustand lösbar oder unlösbar mit dem ersten Bauteil verbunden ist. Durch die determinierte Anschlussposition ist eine besonders fehlerreduzierte Übertragung von Sensordaten von dem Sensorelement durch die Anschlussleitung oder eine Energieversorgung des Sensorelements über die Anschlussleitung gewährleistet. In einer Ausführungsform ist das Sensorelement unlösbar mit der Anschlussleitung verbunden, so dass Sensorelement und Anschlussleitung eine Komponente des Systems ausbilden. In diesem Fall ist die Anschlussleitung dauerhaft in der determinierten Anschlussposition an dem Sensorelement angeschlossen. In einer Ausführungsform ist das Sensorelement in einer separaten Systemkomponente oder in dem ersten Bauteil integriert. Die separate Systemkomponente kann einen Anschlussleitungsabschnitt ausbilden, der mit einem zweiten Anschlussleitungsabschnitt der Anschlussleitung über korrespondierende mechanische Schnittstellen lösbar verbunden ist oder unlösbar verbunden ist unter Ausbildung der Anschlussleitung in dem Betriebszustand. In einer Ausführungsform ist das Sensorelement in dem ersten Bauteil integriert. Bei einer lösbaren Verbindung von Anschlussleitung und Sensorelement in dem Betriebszustand ist dabei stets vorgesehen, dass das Sensorelement bzw. die das Sensorelement umfassende Komponente des Systems, insbesondere das das Sensorelement umfassende erste Bauteil, zueinander korrespondierende mechanische Schnittstellen aufweisen, über die die determinierte Anschlussposition in dem Betriebszustand festgelegt ist.

In einer Ausführungsform sind die beiden Bauteile, d. h. erstes und zweites Bauteil, in dem Betriebszustand ausschließlich über das Sensorelement und die Anschlussleitung miteinander verbunden, wobei die Übertragung von Sensordaten ausschließlich optisch über die Anschlussleitung erfolgt. Indem erstes und zweites Bauteil in dem Betriebszustand ausschließlich über die Anschlussleitung verbunden sind, kann zum einen der Betriebszustand auf besonders einfache Weise realisierbar sein und darüber hinaus eine möglichst geringe Kopplung zwischen erstem und zweitem Bauteil zur Realisierung des Betriebszustands erforderlich sein, was insbesondere zur Fehlervermeidung bei der Messung und zur Vermeidung von Beschädigung oder einer Einflussnahme auf das erste Bauteil vorteilhaft sein kann. Besonders bevorzugt ist die Anschlussleitung ausschließlich als Lichtleiter ausgebildet.

In einer Ausführungsform ist das zweite Bauteil dazu ausgebildet, zur Energieversorgung über die Anschlussleitung Licht mit einem ersten wellenlängenabhängigen Intensitätsverlauf an das Sensorelement auszugeben und als Sensordaten von dem Sensorelement Licht mit einem zweiten wellenlängenabhängigen Intensitätsverlauf zu empfangen und zu verarbeiten zum Ausgeben eines Werts für die Stromstärke. Dabei unterscheidet sich der erste wellenlängenabhängige Intensitätsverlauf von dem zweiten wellenlängenabhängigen Intensitätsverlauf. Der wellenlängenabhängige Intensitätsverlauf von Licht gibt die Intensität des Lichts mit ihrer Wellenlängenabhängigkeit an. Das Integral des wellenlängenabhängigen Intensitätsverlaufs über die Wellenlänge ergibt somit die Gesamtintensität des Lichts. Erster und zweiter wellenlängenabhängiger Intensitätsverlauf können sich beispielsweise darin unterscheiden, dass das Integral über den ersten wellenlängenabhängigen Intensitätsverlauf und somit die Intensität des Lichts mit dem ersten wellenlängenabhängigen Intensitätsverlauf größer ist als das Integral des zweiten wellenlängenabhängigen Intensitätsverlaufs über die Wellenlänge, das die Intensität des Lichts mit dem zweiten wellenlängenabhängigen Intensitätsverlauf angibt. Ferner, insbesondere zusätzlich, können sich erster und zweiter wellenlängenabhängiger Intensitätsverlauf in ihrer Wellenlängenabhängigkeit unterscheiden, so dass der erste wellenlängenabhängige Intensitätsverlauf eine andere Wellenlängenabhängigkeit und somit eine andere Verlaufskontur aufweist als der zweite wellenlängenabhängige Intensitätsverlauf. Besonders bevorzugt weist der erste wellenlängenabhängige Intensitätsverlauf eine andere mittlere Wellenlänge als der zweite wellenlängenabhängige Intensitätsverlauf auf, wobei die mittlere Wellenlänge ermittelt wird durch Mittelwertbildung über sämtlichen Wellenlängen des Intensitätsverlaufs, an denen die der jeweiligen Wellenlänge zugeordnete Intensität mindestens 5 % des Maximums des Intensitätsverlaufs beträgt, wobei bei der Mittelwertbildung die Wellenlängen mit ihrer jeweils zugeordneten Intensität des Intensitätsverlaufs gewichtet werden. Die Gewichtung kann beispielsweise dadurch erfolgen, dass bei der Berechnung der mittleren Wellenlänge sämtliche Wellenlängen, die in die Mittelwertbildung einfließen, mit der ihnen jeweils zugeordneten Intensität des wellenlängenabhängigen Intensitätsverlaufs multipliziert werden unter Erzeugung eines jeweiligen Produkts, wobei diese erzeugten Produkte addiert werden unter Erzeugung einer Summe, wobei diese Summe dividiert wird durch die Summe der Intensitäten, die den genannten Wellenlängen jeweils zugeordnet sind. Besonders bevorzugt ist die mittlere Wellenlänge des ersten wellenlängenabhängigen Intensitätsverlaufs kleiner als die mittlere Wellenlänge des zweiten wellenlängenabhängigen Intensitätsverlaufs. Bei einer besonders bevorzugten Ausführungsform kann durch das zweite Bauteil in dem Betriebszustand sowohl eine Energieversorgung und somit Anregung des Sensorelements erfolgen als auch ein Auslesen des Sensorelements bzw. der Sensordaten von dem Sensorelement. Dabei ist bevorzugt der zweite wellenlängenabhängige Intensitätsverlauf von dem an dem Sensorelement anliegenden Magnetfeld abhängig. Dies ist insbesondere bei der Ausgestaltung des Sensorelements als Festkörperelement realisierbar, bei dem sich für die Elektronen in Abhängigkeit von dem anliegenden Magnetfeld unterschiedliche Energieniveaus einstellen, so dass bei dem Anregen des Sensorelements mit einem stets unveränderten ersten wellenlängenabhängigen Intensitätsverlauf das Sensorelement bei einer Rekombination in Abhängigkeit von dem jeweiligen, durch das jeweils anliegende Magnetfeld eingestellte Energieniveau Licht mit einem von dem Magnetfeld abhängigen zweiten wellenlängenabhängigen Intensitätsverlauf abstrahlt. In einer Ausführungsform umfasst das Sensorelement ein Material, das unterschiedliche Energieniveaus für seine Elektronen aufweist, wobei zumindest eines der Energieniveaus in Präsenz eines Magnetfelds veränderbar ist, wobei selbstverständlich auf die Präsenz eines externen Magnetfelds abgestellt ist, in dem das Sensorelement und somit das Material, das das Sensorelement umfasst, angeordnet ist, beispielsweise durch das von dem durch den Leiter fließenden Strom erzeugten Magnetfeld ein solches externes Magnetfeld ist, in dem im Betriebszustand des Systems das Sensorelement angeordnet ist.

Erfindungsgemäß umfasst das zweite Bauteil eine Lichtquelle und einen Lichtsensor. Die Lichtquelle kann beispielsweise als LED oder als Laserdiode ausgebildet sein. Der Lichtsensor kann beispielsweise eine Photodiode umfassen, insbesondere nur eine Photodiode oder eine Photodiodenanordnung sein oder als CCD-Chip ausgebildet sein. Erstes Bauteil, zweites Bauteil, Sensorelement und Anschlussleitung sind dabei bevorzugt dergestalt zueinander korrespondierend ausgebildet, dass in dem Betriebszustand das Sensorelement durch einen ausgehend von der Lichtquelle des zweiten Bauteils erzeugten, über die Anschlussleitung an das Sensorelement übertragenen Lichtstrahl, insbesondere Lichtpuls, der einen ersten wellenlängenabhängigen Intensitätsverlauf aufweist, zur Abgabe einer Fluoreszenzstrahlung mit einem zweiten wellenlängenabhängigen Intensitätsverlauf anregbar ist, die in dem Betriebszustand über die Anschlussleitung an das zweite Bauteil übertragbar und deren wellenlängenabhängiger Intensitätsverlauf durch den Lichtsensor auflösbar ist, wobei der zweite wellenlängenabhängige Intensitätsverlauf bei gleichbleibendem ersten wellenlängenabhängigen Intensitätsverlauf von dem Magnetfeld abhängt. Das zweite Bauteil ist somit dazu ausgebildet, in dem Betriebszustand über seine Lichtquelle Licht mit einem ersten wellenlängenabhängigen Intensitätsverlauf auszugeben, insbesondere in Form eines Lichtpulses, und dieses Licht in die Anschlussleitung einzuspeisen, über die es an das Sensorelement übertragen wird, wobei das zweite Bauteil ferner dazu ausgebildet ist, nach Aussenden dieses Lichts ebenfalls über die Anschlussleitung von dem Sensorelement Licht mit dem wellenlängenabhängigen Intensitätsverlauf zu empfangen und den zweiten wellenlängenabhängigen Intensitätsverlauf über seinen Lichtsensor aufzulösen. Die Auflösung des zweiten wellenlängenabhängigen Intensitätsverlaufs kann dabei beispielsweise eine Auflösung der Gesamtintensität in einem festgelegten Wellenlängenbereich sein, d.h. das Unterscheiden unterschiedlicher Gesamtintensitäten in diesem Wellenlängenbereich, und/oder eine Auflösung der Wellenlängenabhängigkeit des Intensitätsverlaufs, d. h. das Ausgeben von jeweils einer Intensität für jeweils eine diskrete Wellenlänge oder einen diskreten Wellenlängenbereich, und dies für eine Vielzahl an unterschiedlichen diskreten Wellenlängen bzw. -bereichen. Besonders bevorzugt ist dabei der Lichtsensor dergestalt ausgebildet, dass er eine so hohe Auflösung des zweiten wellenlängenabhängigen Intensitätsverlaufs ermöglicht, das mit dem System in dem Betriebszustand unterschiedliche elektrische Ströme mit einer Auflösung von mindestens 50 mA, insbesondere mindestens 10 mA, insbesondere mindestens 5 mA, insbesondere mindestens 1 mA auflösbar sind. Hierzu sind der Lichtsensor des zweiten Bauteils, die Lichtquelle des zweiten Bauteils, die Anschlussleitung und das Sensorelement entsprechend zueinander korrespondierend ausgebildet. Allgemein hat sich als besonders vorteilhaft herausgestellt, den Lichtsensor so auszugestalten, dass durch den Lichtsensor die Gesamtintensität des auf den Lichtsensor auftreffenden Lichts in einem bestimmten Wellenlängenbereich oder jeweils die Gesamtintensität in mehreren bestimmten Wellenlängenbereichen ermittelt wird, wobei die mehreren bestimmten Wellenlängenbereiche wellenlängenbezogen voneinander beabstandet sind. Beispielsweise kann ein solcher Lichtsensor einen Filter umfassen, der nur Licht in dem bestimmten Wellenlängenbereich durchlässt, wobei bei dem Vorsehen von mehreren bestimmten Wellenlängenbereichen beispielsweise der Filter veränderbar ist zum Filtern des Lichts in den verschiedenen bestimmten Wellenlängenbereichen, wobei dann nacheinander zu jedem bestimmten Wellenlängenbereich die Gesamtintensität ermittelt wird, oder beispielsweise der Lichtsensor mehrere Filter umfassen kann, die jeweils einem bestimmten Wellenlängenbereich zugeordnet sind, wobei hinter jedem Filter eine separate Gesamtintensitätsmessung vorgenommen wird. In einer Ausführungsform umfasst der Lichtsensor eine Photodiode. Besonders bevorzugt begrenzt die Photodiode den bestimmten Wellenlängenbereich durch ihre inhärente, auf einen bestimmten Wellenlängenbereich begrenzte Sensitivität für eine Intensität, wobei zur Gesamtintensitätsmessung ein Messwert aus der Photodiode, insbesondere ein Messwert, der den durch das Licht in der Photodiode erzeugten Strom kennzeichnet, ausgegeben wird. Besonders bevorzugt ist der bestimmte Wellenlängenbereich ausschließlich durch die Photodiode und somit ohne das Vorsehen eines Filters festgelegt. Als besonders vorteilhaft hat sich herausgestellt, als Material des Sensorelements ein paramagnetisches Material vorzusehen. Allgemein ist das Material bevorzugt dergestalt ausgebildet, dass sich bei der Präsenz eines Magnetfelds eine Aufspaltung der Energieniveaus gemäß dem Zeeman-Effekt ergibt. Erfindungsgemäß ist als Material des Sensorelements ein Diamantkristall mit einer Vielzahl an Stickstoff-Fehlstellen-Zentren verwendet.

Besonders bevorzugt ist die Auswerteeinrichtung dazu ausgebildet, bei einer Stromführung durch den Leiter in einem Amperebereich zwischen 100 mA 500 mA, insbesondere zwischen 100 mA und 1 kA, insbesondere zwischen 50 mA und 1,5 kA einen Wert für den durch den Leiter fließenden Strom mit einer Auflösung von mindestens 50 mA, insbesondere mindestens 10 mA, insbesondere mindestens 5 mA auszugeben. Hierzu ist das Sensorelement in seiner Betriebsposition geeignet an dem elektrischen Leiter positionsfest fixiert und das zweite Bauteil und die Anschlussleitung entsprechend ausgebildet, so dass eine Veränderung der Stromstärke und somit des an dem Sensorelement anliegenden Magnetfelds über die über die Anschlussleitung von dem Sensorelement ausgelesenen Sensordaten mit einer hinreichenden Auflösung durch die Auswerteeinrichtung aufgelöst werden können.

Allgemein ist bevorzugt die Anschlussleitung mit dem ersten Bauteil oder mit dem zweiten Bauteil unlösbar verbunden. In einer Ausführungsform umfasst die Anschlussleitung zwei Anschlussleitungsabschnitte, wobei der erste Anschlussleitungsabschnitt mit dem ersten Bauteil unlösbar verbunden ist und das Sensorelement mit dem ersten Bauteil unlösbar verbunden ist und wobei der zweite Anschlussleitungsabschnitt mit dem zweiten Bauteil unlösbar verbunden ist. Zwischen Anschlussleitungsabschnitten können entsprechende zueinander korrespondierende mechanische Schnittstellen ausgebildet sein, die eine möglichst fehlerfreie optische Übertragung zwischen den Anschlussleitungsabschnitten in dem Betriebszustand gewährleisten. Allgemein weisen bevorzugt das erste Bauteil und das zweite Bauteil zueinander korrespondierende mechanische Verbindungseinrichtungen auf, über die die beiden Bauteile zur Realisierung des Betriebszustands miteinander lösbar verbindbar sind und die eine relative Position eines Abschnitts des ersten Bauteils zu einem Abschnitt des zweiten Bauteils zueinander in dem Betriebszustand eindeutig festlegen, wobei bevorzugt zumindest eines der Bauteile zumindest einen Abschnitt der Anschlussleitung umfasst und die Bauteile über die Anschlussleitung miteinander verbunden sind. Besonders bevorzugt liegt in dem Betriebszustand das erste Ende der Anschlussleitung unmittelbar an einem optischen Anschluss des Sensorelements an und liegt das zweite Ende der Anschlussleitung unmittelbar an einem optischen Anschluss des zweiten Bauteils an.

Die Erfindung betrifft ferner ein Verfahren gemäß Anspruch 11 zur Messung einer Stromstärke eines durch einen elektrischen Leiter fließenden Stroms. Der elektrische Leiter ist in einem ersten Bauteil integriert. Bei einem Verfahren wird ein positionsfest zum elektrischen Leiter fixiertes magnetfeldsensitives Sensorelement über eine Anschlussleitung mit einem zweiten Bauteil verbunden, in dem eine Auswerteeinrichtung integriert ist, wobei das Sensorelement über die Anschlussleitung durch die Auswerteeinrichtung ausgelesen wird. Als Anschlussleitung wird ein Lichtleiter verwendet. Die beiden Bauteile werden über die Anschlussleitung lösbar miteinander verbunden, während eine zwischen den beiden Bauteilen bestehende galvanische Trennung aufrechterhalten wird, wobei gleichzeitig über die Anschlussleitung eine optische Verbindung, insbesondere ausschließlich eine optische Verbindung neben der per se vorhandenen mechanischen Verbindung, zwischen Sensorelement und zweitem Bauteil bereitgestellt wird. Dabei ist zu berücksichtigen, dass die beiden Bauteile zwei separate Bauteile sind, die per se voneinander galvanisch getrennt sind, wobei während der Durchführung des erfindungsgemäßen Verfahrens, während derer die beiden Bauteile über die Anschlussleitung lösbar miteinander verbunden werden, die bestehende galvanische Trennung aufrechterhalten wird. Nachdem die beiden Bauteile über die Anschlussleitung miteinander verbunden worden sind, wird durch die lichtleitende Verbindung das magnetfeldsensitive Sensorelement von dem zweiten Bauteil mit Energie versorgt und/oder werden Sensordaten von dem magnetfeldsensitiven Sensorelement zu der Auswerteeinrichtung übertragen. Das Sensorelement umfasst ein Material, das unterschiedliche Energieniveaus für seine Elektronen aufweist, wobei zumindest eines der Energieniveaus in Präsenz eines Magnetfeldes veränderbar ist. Mit einer Lichtquelle des zweiten Bauteils wird ein Lichtstrahl, der einen ersten wellenlängenabhängigen Intensitätsverlauf aufweist, erzeugt und über die Anschlussleitung an das Sensorelement übertragen, und das Material des Sensorelements wird durch den Lichtstrahl zur Abgabe einer Fluoreszenzstrahlung mit einem zweiten wellenlängenabhängigen Intensitätsverlauf angeregt. Die Fluoreszenzstrahlung mit dem zweiten wellenlängenabhängigen Intensitätsverlauf über die Anschlussleitung an das zweite Bauteil übertragen, wobei der zweite wellenlängenabhängige Intensitätsverlauf bei gleichbleibendem ersten wellenlängenabhängigen Intensitätsverlauf von dem Magnetfeld abhängt. Der zweite wellenlängenabhängiger Intensitätsverlauf der Fluoreszenzstrahlung wird durch den Lichtsensor des zweiten Bauteils aufgelöst. Als Material des Sensorelements wird ein Diamantkristall mit einer Vielzahl an Stickstoff-Fehlstellen-Zentren verwendet. Das erfindungsgemäße Verfahren kann weitere Merkmale aufweisen, die im Zusammenhang mit dem erfindungsgemäßen System erläutert sind. Das erfindungsgemäße System und das erfindungsgemäße Verfahren können ferner jeweils weitere Merkmale aufweisen, die im Zusammenhang mit im Stand der Technik bekannten Verfahren bzw. Systemen obenstehend erläutert sind.

Die Erfindung wird nachfolgend unter Bezugnahme auf zwei Figuren anhand eines Ausführungsbeispiels näher erläutert.

Es zeigen:
- Figur 1:: in einer schematischen Prinzipdarstellung eine Ausführungsform eines erfindungsgemäßen Systems in seinem Betriebszustand;
- Figur 2:: in einer schematischen Prinzipdarstellung eine vergrößerte Darstellung von Komponenten des erfindungsgemäßen Systems gemäß Figur 1 in dem Betriebszustand.

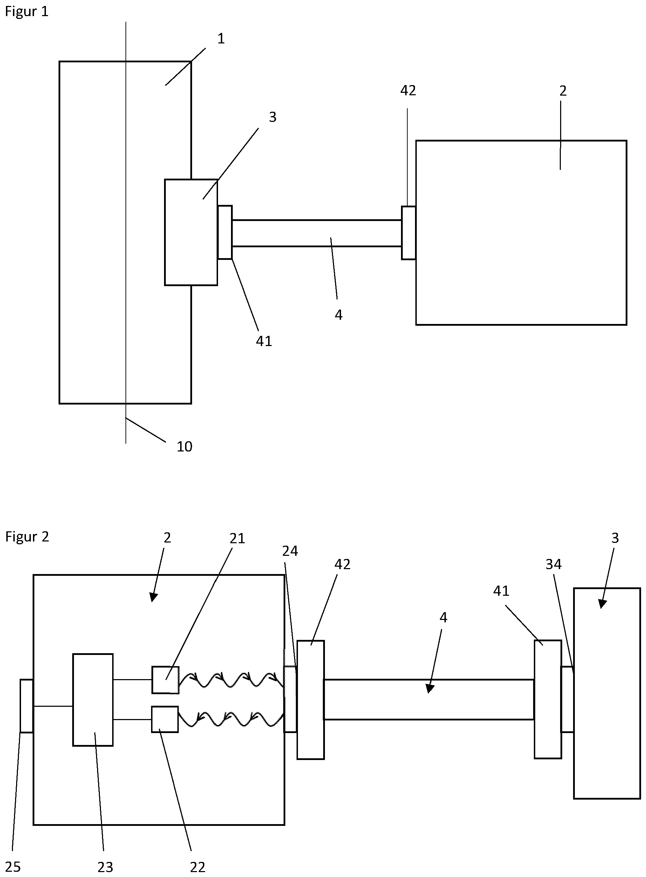

Die in den Figuren 1 und 2 dargestellte Ausführungsform eines erfindungsgemäßen Systems weist ein erstes Bauteil 1 auf, in dem ein elektrischer Leiter 10 integriert ist. Das System weist ferner ein zweites Bauteil 2 auf, in dem eine Auswerteeinrichtung 23 sowie eine Lichtquelle 21 und ein Lichtsensor 22 integriert sind. Das System weist ferner ein magnetfeldsensitives Sensorelement 3 sowie eine Anschlussleitung 4 auf. Bei der beschriebenen Ausführungsform sind das erste Bauteil 1, das zweite Bauteil 2, die Anschlussleitung 4 und das Sensorelement 3 voneinander separate Komponenten des Systems, die jedoch in dem Betriebszustand eine determinierte Anordnung, und somit jeweils festgelegte Position zueinander einnehmen. Die Anschlussleitung 4 ist als durchgehender Lichtleiter ausgebildet, was erfindungsgemäß allgemein vorteilhaft ist. Die Anschlussleitung 4 erstreckt sich von ihrem ersten Ende bis zu ihrem zweiten Ende und verläuft sowohl zwischen ihren Enden ununterbrochen als auch in ihrem Querschnitt, der sich senkrecht zu ihrem Verlauf zwischen ihren Enden erstreckt, ununterbrochen, was erfindungsgemäß ebenfalls allgemein vorteilhaft ist. Durch die ununterbrochene Ausgestaltung der Anschlussleitung 4 ist der Aufbau des erfindungsgemäßen Systems besonders vereinfacht, und Fehler können besonders vorteilhaft vermieden sein.

Bei der beschriebenen Ausführungsform ist der elektrische Leiter 10 in dem ersten Bauteil 1 positionsfest fixiert, und das erste Bauteil 1 weist als mechanische Schnittstelle eine Aufnahme auf, in die eine Seite des Sensorelements 3, die als eine mechanische Schnittstelle des Sensorelements 3 ausgebildet ist, in Passung einsetzbar ist zum Erreichen des Betriebszustands, wobei in dem Betriebszustand die korrespondierenden mechanischen Schnittstellen eine Verrastung der durch sie miteinander verbundenen Elemente gewährleisten, was erfindungsgemäß allgemein vorteilhaft ist. In dem Betriebszustand ist das Sensorelement 3 in der Aufnahme des ersten Bauteils 1 positionsfest fixiert. Das Sensorelement 3 weist eine weitere mechanische Schnittstelle 34 auf, die korrespondierend zu einer an dem ersten Ende der Anschlussleitung 4 ausgebildeten mechanischen Schnittstelle 41 ausgebildet ist, wobei die mechanischen Schnittstellen 34, 41 von Sensorelement 3 und Anschlussleitung 4 dergestalt zueinander korrespondierend ausgebildet sind, dass das Sensorelement 3 in dem Betriebszustand mit seinem optischen Anschluss positionsfest relativ zum ersten Ende der Anschlussleitung 4 fixiert ist und dabei in einer durch die mechanischen Schnittstellen 34, 41 festgelegten Position relativ zum ersten Ende der Anschlussleitung 4 angeordnet und gehalten ist. An ihrem zweiten Ende weist die Anschlussleitung 4 eine zweite mechanische Schnittstelle 42 auf, über die sie in dem Betriebszustand mit einer korrespondierenden mechanischen Schnittstelle 24, die gleichzeitig einen optischen Anschluss des zweiten Bauteils 2 ausbildet, positionsfest verbunden ist, wodurch der Betriebszustand ausgebildet ist, in dem das zweite Ende der Anschlussleitung 4 in einer festgelegten Position am optischen Anschluss des zweiten Bauteils 2 angeordnet ist. In dem Betriebszustand sind somit das Sensorelement 3 und das zweite Bauteil 2 ausschließlich über die Anschlussleitung 4 miteinander verbunden. Entsprechend ist in dem Betriebszustand das erste Bauteil 1, an dem in dem Betriebszustand das Sensorelement 3 positionsfest gehalten ist, ausschließlich über die Anschlussleitung 4 mit dem zweiten Bauteil 2 verbunden.

Das zweite Bauteil 2 weist eine als Laserdiode ausgebildete Lichtquelle 21 sowie einen als Photodiode ausgebildeten Lichtsensor 22 auf. Lichtquelle 21 und Lichtsensor 22 sind mit einer von dem zweiten Bauteil 2 umfassten Auswerteeinrichtung 23 verbunden, die einen Mikroprozessor und einen Speicher umfasst, was erfindungsgemäß allgemein vorteilhaft ist. Über die Auswerteeinrichtung 23 sind zum einen Lichtquelle 21 und Lichtsensor 22 ansteuerbar und ist zum anderen der Lichtsensor 22 auslesbar, was erfindungsgemäß allgemein vorteilhaft ist. Das zweite Bauteil 2 ist dazu ausgebildet, in dem Betriebszustand über seine Lichtquelle 21 einen Lichtpuls mit einem ersten wellenlängenabhängigen Intensitätsverlauf an das Sensorelement 3 auszugeben und mit seinem Lichtsensor 22 den zweiten wellenlängenabhängigen Intensitätsverlauf aufzulösen, wobei dieser zweite wellenlängenabhängige Intensitätsverlauf das Licht charakterisiert, das das Sensorelement 3 als Reaktion darauf aussendet, dass es durch Licht von der Lichtquelle 21 angeregt wurde. Das Sensorelement 3 ist vorliegend als NV-Diamantkristall ausgebildet, bei dem gemäß dem Zeman-Effekt eine Aufspaltung von Energieniveaus bei dem Anliegen eines Magnetfelds auftritt. Durch die räumlich nahe Anordnung des Sensorelements 3 an dem elektrischen Leiter 10 des ersten Bauteils 1 in dem Betriebszustand ist bei dem Fließen eines elektrischen Stroms durch den elektrischen Leiter 10 das Sensorelement 3 in dem von dem elektrischen Strom zwangsweise erzeugten magnetischen Feld angeordnet. Aufgrund der Magnetfeldstärkeabhängigkeit von Energieniveaus des Sensorelements 3 verändert sich der zweite wellenlängenabhängige Intensitätsverlauf in Abhängigkeit von der durch den durch den elektrischen Leiter 10 fließenden Strom am Sensorelement erzeugten Magnetfeldstärke, wenn das Sensorelement 3 mit stets demselben ersten wellenlängenabhängigen Intensitätsverlauf durch die Lichtquelle 21 angeregt wird. Die Auswerteeinrichtung 23 ist dazu ausgebildet, den Lichtsensor 22 auszulesen, um die Gesamtintensität des zweiten wellenlängenabhängigen Intensitätsverlauf in einem von der Photodiode festgelegten Wellenlängenbereich zu ermitteln. Die Auswerteeinrichtung 23 ist dazu eingerichtet, die ermittelte Gesamtintensität in eine Information bezüglich der durch den elektrischen Leiter 10 fließenden Stromstärke umzuwandeln. In einer weiteren Ausführungsform ist der Lichtsensor 22 als CCD-Chip oder sonstige Einrichtung ausgebildet, durch die für unterschiedliche diskrete Wellenlängenbereiche eine jeweils zugeordnete Intensität ermittelbar ist. Besonders bevorzugt wird dabei eine über die Intensität gemittelte mittlere Wellenlänge des zweiten wellenlängenabhängigen Intensitätsverlaufs ermittelt, d. h. ein Mittelwert der Wellenlänge des zweiten wellenlängenabhängigen Intensitätsverlaufs ermittelt, wobei bei der Mittelwertbildung die jeweilige Wellenlänge mit dem jeweiligen Intensitätswert zu der jeweiligen Wellenlänge des wellenlängenabhängigen Intensitätsverlaufs gewichtet wird. Die Auswerteeinrichtung 23 ist dazu ausgebildet, die Wellenlängeninformationen betreffend die Wellenlänge des zweiten Wellenlängenspektrums zu verarbeiten und in eine Information bezüglich der durch den elektrischen Leiter 10 fließenden Stromstärke umzuwandeln. Diese jeweilige Information bezüglich der Stromstärke gibt das zweite Bauteil 2 in dem Betriebszustand an seinem Ausgang 25 aus.

In anderen Ausführungsformen ist die Auswerteeinrichtung 23 lediglich dazu ausgebildet, zumindest eine Wellenlänge des zweiten wellenlängenabhängigen Intensitätsverlaufs zu ermitteln und diese an dem Ausgang 25 des zweiten Bauteils auszugeben, wobei eine weitere Vorrichtung an dem Ausgang 25 angeschlossen ist, die die jeweils ermittelte zumindest eine Wellenlänge einem bestimmten Stromwert zuordnet.

### Bezugszeichenliste

- 1: erstes Bauteil
- 2: zweites Bauteil
- 3: magnetfeldsensitives Sensorelement
- 4: Anschlussleitung
- 10: elektrischer Leiter
- 21: Lichtquelle
- 22: Lichtsensor
- 23: Auswerteeinrichtung
- 24: mechanische Schnittstelle
- 25: Ausgang
- 34: mechanische Schnittstelle
- 41: erste mechanische Schnittstelle
- 42: zweite mechanische Schnittstelle

## Patentansprüche

1. System zur Messung einer Stromstärke eines durch einen elektrischen Leiter (10) fließenden Stroms, das System umfassend ein erstes Bauteil (1), das den elektrischen Leiter (10) umfasst, sowie ein zweites, von dem ersten Bauteil (1) separates Bauteil (2), das eine Auswerteeinrichtung (23) umfasst, sowie ein magnetfeldsensitives Sensorelement (3) und eine Anschlussleitung (4), wobei in einem Betriebszustand das Sensorelement (3) in einer relativ zu dem elektrischen Leiter (10) determinierten Betriebsposition positionsfest an dem ersten Bauteil (1) fixiert ist und durch die Anschlussleitung (4) mit dem zweiten Bauteil (2) verbunden ist, indem die Anschlussleitung (4) mit einem ersten Ende an dem Sensorelement (3) und mit einem zweiten Ende an dem zweiten Bauteil (2) angeschlossen ist, wobei die Anschlussleitung (4) ein Lichtleiter ist, wobei in dem Betriebszustand die beiden Bauteile (1, 2) voneinander galvanisch getrennt sind und mittels der Anschlussleitung (4) mit einer lichtleitenden Verbindung lösbar miteinander verbunden sind, wobei durch die lichtleitende Verbindung eine Energieversorgung des magnetfeldsensitiven Sensorelements (3) durch das zweite Bauteil (2) und eine Übertragung von Sensordaten von dem magnetfeldsensitiven Sensorelement (3) zu der Auswerteeinrichtung (23) gewährleistet ist, wobei das Sensorelement (3) ein Material umfasst, das unterschiedliche Energieniveaus für seine Elektronen aufweist, wobei zumindest eines der Energieniveaus in Präsenz eines Magnetfeldes veränderbar ist, wobei das zweite Bauteil (2) eine Lichtquelle (21) und einen Lichtsensor (22) umfasst, wobei in dem Betriebszustand das Material durch einen ausgehend von der Lichtquelle (21) des zweiten Bauteils (2) erzeugten, über die Anschlussleitung (4) an das Sensorelement (3) übertragenen Lichtstrahl, der einen ersten wellenlängenabhängigen Intensitätsverlauf aufweist, zur Abgabe einer Fluoreszenzstrahlung mit einem zweiten wellenlängenabhängigen Intensitätsverlauf anregbar ist, die in dem Betriebszustand über die Anschlussleitung (4) an das zweite Bauteil (2) übertragbar ist, wobei der zweite wellenlängenabhängige Intensitätsverlauf bei gleichbleibendem ersten wellenlängenabhängigen Intensitätsverlauf von dem Magnetfeld abhängt,
wobei der zweite wellenlängenabhängige Intensitätsverlauf der Fluoreszenzstrahlung durch den Lichtsensor (22) auflösbar ist, **dadurch gekennzeichnet, dass** als Material des Sensorelements ein Diamantkristall mit einer Vielzahl an Stickstoff-Fehlstellen-Zentren verwendet ist.

2. System nach Anspruch 1,
**dadurch gekennzeichnet, dass**
entweder die Anschlussleitung (4) unlösbar an einer Anschlusseinrichtung des zweiten Bauteils (2) angeschlossen ist, oder dass die Anschlussleitung (4) durch zusammenwirkende, an ihrem zweiten Ende und an dem zweiten Bauteil (2) vorgesehene mechanische Schnittstellen (24, 25, 41, 42) in dem Betriebszustand lösbar an der Anschlusseinrichtung des zweiten Bauteils (2) angeschlossen ist.

3. System nach einem der vorangehenden Ansprüche,
**dadurch gekennzeichnet, dass**
das Sensorelement (3) in dem ersten Bauteil (1) relativ zu dem Leiter (10) positionsfest integriert ist.

4. System nach einem der Ansprüche 1 oder 2,
**dadurch gekennzeichnet, dass**
das Sensorelement (3) durch zusammenwirkende mechanische Schnittstellen (24, 25, 41, 42) von Sensorelement (3) und erstem Bauteil (1) in dem Betriebszustand lösbar in der determinierten Betriebsposition an dem ersten Bauteil (1) fixiert ist.

5. System nach einem der vorangehenden Ansprüche,
**dadurch gekennzeichnet, dass**
die Anschlussleitung (4) in dem Betriebszustand in einer determinierten Anschlussposition an dem Sensorelement (3) angeschlossen ist, wobei die Anschlussleitung (4) in dem Betriebszustand lösbar mit dem ersten Bauteil (1) verbunden ist.

6. System nach einem der Ansprüche 1 bis 3,
**dadurch gekennzeichnet, dass**
die Anschlussleitung (4) in dem Betriebszustand in einer determinierten Anschlussposition an dem Sensorelement (3) angeschlossen ist, wobei die Anschlussleitung (4) in dem Betriebszustand unlösbar mit dem ersten Bauteil (1) verbunden ist.

7. System nach einem der vorangehenden Ansprüche 1 bis 3,
**dadurch gekennzeichnet, dass**
die Anschlussleitung (4) mit dem ersten Bauteil (1) unlösbar verbunden ist.

8. System nach einem der vorangehenden Ansprüche,
**dadurch gekennzeichnet, dass**
die beiden Bauteile (1, 2) in dem Betriebszustand ausschließlich über das Sensorelement (3) und die Anschlussleitung (4) miteinander verbunden sind und die Übertragung von Sensordaten ausschließlich optisch über die Anschlussleitung (4) erfolgt.

9. System nach einem der vorangehenden Ansprüche,
**dadurch gekennzeichnet, dass**
das erste Bauteil (1) und das zweite Bauteil (2) zueinander korrespondierende mechanische Verbindungseinrichtungen aufweisen, über die die beiden Bauteile (1, 2) zur Realisierung des Betriebszustands miteinander verbindbar sind und die eine relative Position eines Abschnitts des ersten Bauteils (1) zu einem Abschnitt des zweiten Bauteils (2) zueinander in dem Betriebszustand eindeutig festlegen, wobei insbesondere in dem Betriebszustand das erste Ende der Anschlussleitung (4) unmittelbar an einem optischen Anschluss des Sensorelements (3) und das zweite Ende der Anschlussleitung (4) unmittelbar an einem optischen Anschluss des zweiten Bauteils (2) anliegt.

10. System nach einem der vorangehenden Ansprüche,
**dadurch gekennzeichnet, dass**
die Auswerteeinrichtung dazu ausgebildet ist, bei einer Stromführung durch den Leiter (10) in einem Amperebereich zwischen 100 mA und 1 kA, insbesondere zwischen 50 mA und 1,5 kA einen Wert für den durch den Leiter fließenden Strom mit einer Auflösung von mindestens 50 mA, insbesondere mindestens 10 mA, insbesondere mindestens 5 mA auszugeben.

11. Verfahren zur Messung einer Stromstärke eines durch einen elektrischen Leiter (10) fließenden Stroms, wobei der elektrische Leiter (10) in einem ersten Bauteil (1) integriert ist, wobei ein positionsfest zum elektrischen Leiter (10) fixiertes magnetfeldsensitives Sensorelement (3) über eine Anschlussleitung (4) mit einem zweiten Bauteil (2) verbunden wird, in dem eine Auswerteeinrichtung (23) integriert ist, und durch die Auswerteeinrichtung (23) ausgelesen wird, wobei als Anschlussleitung (4) ein Lichtleiter verwendet wird, wobei die beiden Bauteile (1, 2) über die Anschlussleitung (4) lösbar miteinander verbunden werden und dabei eine zwischen den beiden Bauteilen (1, 2) bestehende galvanische Trennung aufrechterhalten wird und eine lichtleitende Verbindung zwischen dem zweiten Bauteil (2) und dem Sensorelement (3) bereitgestellt wird, wobei durch die lichtleitende Verbindung das magnetfeldsensitive Sensorelement (3) von dem zweiten Bauteil (2) mit Energie versorgt wird und Sensordaten von dem magnetfeldsensitiven Sensorelement (3) zu der Auswerteeinrichtung (23) übertragen werden, wobei das Sensorelement (3) ein Material umfasst, das unterschiedliche Energieniveaus für seine Elektronen aufweist, wobei zumindest eines der Energieniveaus in Präsenz eines Magnetfeldes veränderbar ist, wobei mit einer Lichtquelle (21) des zweiten Bauteils (2) ein Lichtstrahl, der einen ersten wellenlängenabhängigen Intensitätsverlauf aufweist, erzeugt wird und der Lichtstrahl über die Anschlussleitung an das Sensorelement (3) übertragen wird und das Material des Sensorelements (3) durch den Lichtstrahl zur Abgabe einer Fluoreszenzstrahlung mit einem zweiten wellenlängenabhängigen Intensitätsverlauf angeregt wird, wobei die Fluoreszenzstrahlung mit dem zweiten wellenlängenabhängigen Intensitätsverlauf über die Anschlussleitung (4) an das zweite Bauteil (2) übertragen wird, wobei der zweite wellenlängenabhängige Intensitätsverlauf bei gleichbleibendem ersten wellenlängenabhängigen Intensitätsverlauf von dem Magnetfeld abhängt,
wobei der zweite wellenlängenabhängige Intensitätsverlauf der Fluoreszenzstrahlung durch einen Lichtsensor (22) des zweiten Bauteils (2) aufgelöst wird, **dadurch gekennzeichnet, dass** als Material des Sensorelements ein Diamantkristall mit einer Vielzahl an Stickstoff-Fehlstellen-Zentren verwendet wird.

## Claims

1. System for measuring an intensity of a current flowing through an electrical conductor (10), the system comprising a first component (1) comprising the electrical conductor (10) and a second component (2) separate from the first component (1) and comprising an evaluation device (23), as well as a magnetic field sensitive sensor element (3) and a connection cable (4), wherein in one operating state said sensor element (3) is mounted positionally fixed to the first component (1) in an operating position determined relative to the electrical conductor (10) and is connected to the second component (2) by the connection cable (4), the connection cable (4) being connected with a first end to the sensor element (3) and with a second end to the second component (2), wherein the connection cable (4) is an optical conductor, wherein in the operating state the two components (1, 2) are galvanically isolated from each other and are detachably connected to each other by means of the connecting cable (4) with a light-guiding connection, wherein an energy supply of the magnetic field sensitive sensor element (3) by the second component (2) and a transfer of sensor data from the magnetic field sensitive element (3) to the evaluation device (23) is ensured by the light-guiding connection, wherein the sensor element (3) comprises a material having different energy levels for its electrons, wherein at least one of the energy levels is variable in the presence of a magnetic field, wherein the second component (2) comprises a light source (21) and a light sensor (22), wherein in the operating state the material can be excited by a light beam, which is generated from the light source (21) of the second component (2) and transmitted to the sensor element (3) via the connection cable (4) and has a first wavelength-dependent intensity curve, to emit a fluorescent radiation with a second wavelength-dependent intensity curve which can be transmitted to the second component (2) via the connection cable (4) in the operating state, wherein the second wavelength-dependent intensity curve depends on the magnetic field while the first wavelength-dependent intensity curve is kept constant, wherein the second wavelength-dependent intensity curve of the fluorescent radiation can be resolved by the light sensor (22), **characterized in that**
a diamond crystal having a plurality of nitrogen vacancy centers is used as material of the sensor element.

2. System according to claim 1,
**characterized in that**
either the connection cable (4) is non-detachably connected to a connection device of the second component (2) or the connection cable (4) is detachably connected to the connection device of the second component (2) in the operating state by means of interacting mechanical interfaces (24, 25, 41, 42) provided at its second end and on the second component (2).

3. System according to any one of the preceding claims, **characterized in that**
the sensor element (3) is integrated in the first component (1) positionally fixed relative to the conductor (10).

4. System according to any one of claims 1 or 2, **characterized in that**
the sensor element (3) is detachably fixed to the first component (1) in the determined operating position by interacting mechanical interfaces (24, 25, 41, 42) of the sensor element (3) and the first component (1).

5. System according to any one of the preceding claims, **characterized in that**
the connection cable (4) is connected to the sensor element (3) in a determined connection position in the operating state, the connection cable (4) being detachably connected to the first component (1) in the operating state.

6. System according to any one of claims 1 to 3,
**characterized in that**
the connection cable (4) is connected to the sensor element (3) in a determined connection position in the operating state, the connection cable (4) being non-detachably connected to the first component (1) in the operating state.

7. System according to any one of the preceding claims 1 to 3, **characterized in that**
the connection cable (4) is non-detachably connected to the first component (1).

8. System according to any one of the preceding claims, **characterized in that**
the two components (1, 2) are connected with each other exclusively via the sensor element (3) and the connection cable (4) in the operating state and the transmission of sensor data takes place exclusively optically via the connection cable (4).

9. System according to any one of the preceding claims, **characterized in that**
the first component (1) and the second component (2) comprise mutually corresponding mechanical connection devices by which the two components (1, 2) can be connected with each other for establishing the operating state and clearly define a relative position of a section of the first component (1) to a section of the second component (2) to each other in the operating state, wherein in particular in the operating state the first end of the connection cable (4) is directly applied to an optical connection of the sensor element (3) and the second end of the connection cable (4) is directly applied to an optical connection of the second component (2) .

10. System according to any one of the preceding claims, **characterized in that**
the evaluation device is designed to output a value for the current flowing through the conductor (10) in an ampere range between 100 mA and 1 kA, in particular between 50 mA and 1.5 kA, with a resolution of at least 50 mA, in particular at least 10 mA, in particular at least 5 mA, when the current flows through the conductor (10) .

11. Method for measuring an intensity of a current flowing through an electrical conductor (10), wherein the electrical conductor (10) is integrated in a first component (1), wherein a magnetic field sensitive sensor element (3) mounted positionally fixed to the electric conductor (10) is connected via a connection cable (4) to a second component (2) in which (2) an evaluation device (23) is integrated, and is read out by the evaluation device (23), wherein an optical conductor is used as a connection cable (4), wherein the two components (1, 2) are detachably connected with each other via the connection cable (4), while a galvanic isolation existing between the two components (1, 2) is maintained and a light-conducting connection between the second component (2) and the sensor element (3) is provided, wherein the magnetic field-sensitive sensor element (3) is supplied with energy by the second component (2) through the light-conducting connection and sensor data are transmitted from the magnetic field-sensitive sensor element (3) to the evaluation device (23), wherein the sensor element (3) comprises a material having different energy levels for its electrons, wherein at least one of the energy levels is variable in the presence of a magnetic field, wherein a light beam with a first wavelength-dependent intensity curve is generated with a light source (21) of the second component (2) and the light beam is transmitted to the sensor element (3) via the connection cable and the material of the sensor element (3) is excited by the light beam to emit a fluorescent radiation with a second wavelength-dependent intensity curve, wherein the fluorescent radiation with the second wavelength-dependent intensity curve is transmitted to the second component (2) through the connection cable (4), wherein the second wavelength-dependent intensity curve depends on the magnetic field while the first wavelength-dependent intensity curve is kept constant, wherein the second wavelength-dependent intensity curve of the fluorescent radiation is resolved by a light sensor (22) of the second component, **characterized in that**
a diamond crystal having a plurality of nitrogen vacancy centers is used as material of the sensor element.

## Revendications

1. Système de mesure de l'intensité d'un courant traversant un conducteur électrique (10), le système comprenant un premier composant (1) comprenant le conducteur électrique (10) et un second composant (2) séparé du premier composant (1) et comprenant un dispositif d'évaluation (23), ainsi qu'un élément capteur sensible au champ magnétique (3) et un câble de connexion (4), dans lequel, dans un état de fonctionnement, ledit élément capteur (3) est monté de manière fixe sur le premier composant (1) dans une position de fonctionnement déterminée par rapport au conducteur électrique (10) et est relié au second composant (2) par le câble de connexion (4) étant connecté par une première extrémité à l'élément capteur (3) et par une seconde extrémité au second composant (2), dans lequel le câble de connexion (4) est un conducteur optique, dans lequel les deux composants (1, 2) sont isolés galvaniquement l'un de l'autre à l'état de fonctionnement et sont reliés de manière amovible l'un à l'autre au moyen du câble de connexion (4) avec une connexion conductrice de lumière, dans lequel l'alimentation en énergie de l'élément capteur sensible au champ magnétique (3) par le second composant (2) et un transfert de données de l'élément capteur sensible au champ magnétique (3) au dispositif d'évaluation (23) sont assurés par la connexion conductrice de lumière, dans lequel l'élément capteur (3) comprend un matériau ayant différents niveaux d'énergie pour ses électrons, dans lequel au moins un des niveaux d'énergie est variable en présence d'un champ magnétique, dans lequel le second composant (2) comprend une source de lumière (21) et un capteur de lumière (22), dans lequel, à l'état de fonctionnement, le matériau peut être excité par un faisceau de lumière généré par la source lumineuse (21) du second composant (2) et transmis à l'élément capteur (3) via le câble de connexion (4) et présentant une première allure d'intensités dépendant de la longueur d'onde, pour émettre un rayonnement fluorescent présentant une seconde allure d'intensités dépendant de la longueur d'onde, qui peut être transmis au second composant (2) via le câble de connexion (4) à l'état de fonctionnement, dans lequel la deuxième allure d'intensités dépendant de la longueur d'onde dépend du champ magnétique quand une première allure d'intensités dépendant de la longueur d'onde est maintenue constante, la seconde allure d'intensités dépendant de la longueur d'onde du rayonnement fluorescent pouvant être résolue par le capteur de lumière (22),
**caractérisé en ce que**
un cristal de diamant ayant une pluralité de centres de vacance d'azote est utilisé comme matériau de l'élément capteur.

2. Système selon la revendication 1,
**caractérisé en ce que**
soit le câble de connexion (4) est connecté de manière non amovible à un dispositif de connexion du deuxième composant (2), soit le câble de connexion (4) est connecté de manière amovible au dispositif de connexion du deuxième composant (2) à l'état de fonctionnement au moyen d'interfaces mécaniques en interaction (24, 25, 41, 42) prévues à sa deuxième extrémité et sur le deuxième composant (2).

3. Système selon l'une des revendications précédentes, **caractérisé en ce que**
l'élément capteur (3) est intégré dans le premier composant (1) fixé en position par rapport au conducteur (10).

4. Système selon l'une des revendications 1 ou 2,
**caractérisé en ce que**
l'élément capteur (3) est fixé de manière amovible au premier composant (1) dans la position de fonctionnement déterminée par l'interaction des interfaces mécaniques (24, 25, 41, 42) de l'élément capteur (3) et du premier composant (1).

5. Système selon l'une des revendications précédentes, **caractérisé en ce que**
le câble de connexion (4) est relié à l'élément capteur (3) dans une position de connexion déterminée à l'état de fonctionnement, le câble de connexion (4) étant relié de manière amovible au premier composant (1) à l'état de fonctionnement.

6. Système selon l'une des revendications 1 à 3,
**caractérisé en ce que**
le câble de connexion (4) est relié à l'élément capteur (3) dans une position de connexion déterminée à l'état de fonctionnement, le câble de connexion (4) étant connecté de manière non-amovible au premier composant (1) à l'état de fonctionnement.

7. Système selon l'une des revendications précédentes 1 à 3,
**caractérisé en ce que**
le câble de connexion (4) est relié de manière non amovible au premier composant (1).

8. Système selon l'une des revendications précédentes, **caractérisé en ce que**,
à l'état de fonctionnement, les deux composants (1, 2) sont reliés l'un à l'autre exclusivement par l'intermédiaire de l'élément capteur (3) et du câble de connexion (4) et la transmission des données du capteur s'effectue exclusivement par voie optique via le câble de connexion (4).

9. Système selon l'une des revendications précédentes, **caractérisé en ce que**
le premier composant (1) et le second composant (2) comprennent des dispositifs de connexion mécanique se correspondant mutuellement, par lesquels les deux composants (1, 2) peuvent être connectés l'un à l'autre pour établir l'état de fonctionnement, et définissent clairement une position relative d'une section du premier composant (1) à une section du second composant (2) l'un par rapport à l'autre dans l'état de fonctionnement, en particulier, à l'état de fonctionnement, la première extrémité du câble de connexion (4) est directement reliée à une connexion optique de l'élément capteur (3) et la seconde extrémité du câble de connexion (4) est directement reliée à une connexion optique du second composant (2).

10. Système selon l'une des revendications précédentes, **caractérisé en ce que**
le dispositif d'évaluation est conçu pour délivrer une valeur du courant traversant le conducteur (10) dans une plage d'ampères comprise entre 100 mA et 1 kA, en particulier entre 50 mA et 1,5 kA, avec une résolution d'au moins 50 mA, en particulier d'au moins 10 mA, en particulier d'au moins 5 mA, lorsque le courant traverse le conducteur (10).

11. Procédé de mesure de l'intensité d'un courant traversant un conducteur électrique (10), dans lequel le conducteur électrique (10) est intégré dans un premier composant (1), dans lequel un élément de capteur sensible au champ magnétique (3) monté de manière fixe sur le conducteur électrique (10) est relié par un câble de connexion (4) à un second composant (2) dans lequel (2) un dispositif d'évaluation (23) est intégré et est lu par le dispositif d'évaluation (23), dans lequel un conducteur optique est utilisé comme câble de connexion (4), dans lequel les deux composants (1, 2) sont reliés de manière amovible l'un à l'autre par le câble de connexion (4), tout en maintenant une isolation galvanique entre les deux composants (1, 2) et en établissant une connexion conductrice de lumière entre le second composant (2) et l'élément capteur (3), l'élément capteur sensible au champ magnétique (3) étant alimenté en énergie par le second composant (2) via la connexion conductrice de lumière et les données du capteur étant transmises de l'élément capteur sensible au champ magnétique (3) au dispositif d'évaluation (23), dans lequel l'élément capteur (3) comprend un matériau ayant différents niveaux d'énergie pour ses électrons, dans lequel au moins un des niveaux d'énergie est variable en présence d'un champ magnétique, dans lequel un faisceau lumineux avec une première allure d'intensités dépendant de la longueur d'onde est généré par une source lumineuse (21) du second composant (2) et le faisceau lumineux est transmis à l'élément capteur (3) via le câble de connexion et le matériau de l'élément capteur (3) est excité par le faisceau lumineux pour émettre un rayonnement fluorescent avec une deuxième allure d'intensités dépendant de la longueur d'onde, le rayonnement fluorescent avec la deuxième allure d'intensités dépendant de la longueur d'onde est transmis au deuxième composant (2) via le câble de connexion (4), dans lequel la deuxième allure d'intensités dépendant de la longueur d'onde dépend du champ magnétique quand la première allure d'intensités dépendant de la longueur d'onde est maintenue constante, la deuxième allure d'intensités dépendant de la longueur d'onde du rayonnement fluorescent étant résolue par un capteur de lumière (22) du deuxième composant,
**caractérisé en ce que**
un cristal de diamant ayant une pluralité de centres de vacance d'azote est utilisé comme matériau de l'élément capteur.
